# EUROPEAN PATENT APPLICATION

(11) **EP 4 823 016 A1**
(43) Date of publication of application: **14.10.2026**
(21) Application number: 24899815.5
(22) Date of filing: 03.12.2024
(51) Int. Cl.: H04L 1/00

(54) **INTERLEAVING METHOD AND COMMUNICATION APPARATUS**

(30) Priority: 04.12.2023 CN 202311665402
(71) Applicant: Huawei Technologies Co., Ltd., Shenzhen, Guangdong 518129 (CN)
(72) Inventor: LIU, Ke, Shenzhen, Guangdong 518129 (CN); TONG, Jiajie, Shenzhen, Guangdong 518129 (CN); ZHANG, Huazi, Shenzhen, Guangdong 518129 (CN); QIN, Kangjian, Shenzhen, Guangdong 518129 (CN); WANG, Xianbin, Shenzhen, Guangdong 518129 (CN); WANG, Jun, Shenzhen, Guangdong 518129 (CN)
(74) Representative: Huawei European IPR
(86) International application number: PCT/CN2024/136490
(87) International publication number: WO 2025/119177

(57) **Abstract**

An interleaving method in channel coding and a communication apparatus are disclosed, to incorporate a degree of a variable node when interleaving is performed on a to-be-interleaved codeword sequence. Based on a concept of degree-based interleaving, bits in a codeword sequence obtained through interleaving and energy levels of bit positions included in a QAM symbol satisfy the following: A column with a larger column weight corresponds to a bit position at a low energy level in the QAM symbol, and a column with a smaller column weight corresponds to a bit position at a high energy level in the QAM symbol. According to the interleaving method, hardware complexity of interleaving can be reduced, and interleaving performance better than that of row-column interleaving can be further achieved.

## Description

This application claims priority to Chinese Patent Application No. 202311665402.9, filed with the China National Intellectual Property Administration on December 4, 2023 and entitled "INTERLEAVING METHOD AND COMMUNICATION APPARATUS", which is incorporated herein by reference in its entirety.

### TECHNICAL FIELD

This application relates to the channel coding field, and more specifically, to an interleaving method in channel coding and a related communication apparatus.

### BACKGROUND

Low-density parity-check (low density parity check, LDPC) codes are a type of a channel coding scheme that can approach the Shannon limit very closely, and is characterized by excellent performance and low complexity. Currently, they have been adopted by the 3rd generation partnership project (3rd generation partnership project, 3GPP) as a data channel coding scheme for 5th generation (the 5th generation, 5G) mobile networks.

To improve decoding performance, LDPC generally employ row-column bit interleaving, to map system bits of LDPC to high-energy bits in quadrature amplitude modulation (quadrature amplitude modulation, QAM), to protect the system bits of LDPC. Through row-column interleaving, even if overall correctness of coded bits cannot be achieved in final LDPC decoding, correctness of information bits can be improved. However, the hardware implementation of the row-column interleaving process is complex, and in high-throughput scenarios, severely affects an overall decoding rate, becoming a bottleneck for system decoding throughput.

### SUMMARY

This application provides an interleaving method and a communication apparatus, to reduce hardware complexity of interleaving while keeping interleaving performance basically unchanged.

According to a first aspect, an interleaving method is provided. The method includes: obtaining a to-be-interleaved first codeword sequence, where the first codeword sequence corresponds to a base matrix of a low-density parity-check LDPC code, column weights of columns included in the base matrix are related to energy levels of bit positions included in a quadrature amplitude modulation QAM symbol, the first codeword sequence includes X groups, X is greater than or equal to 2, and X is a positive integer; interleaving the first codeword sequence to obtain a second codeword sequence; mapping the second codeword sequence to the QAM symbol; and outputting a modulated QAM symbol.

In the technical solution of this application, the first codeword sequence is interleaved by "degree", so that the column weights of the base matrix (or degrees of a tanner graph) are related to the energy levels of the bit positions included in the QAM symbol, to reduce hardware complexity of interleaving, and further improve interleaving performance.

With reference to the first aspect, in some implementations of the first aspect, that the column weights of the base matrix are related to the energy levels of the bit positions included in the QAM symbol includes: The column weights of the base matrix include at least two ranges, a minimum column weight in a first range of the at least two ranges is greater than a maximum column weight in a second range of the at least two ranges, and an energy level corresponding to the first range is less than an energy level corresponding to the second range. Alternatively, an average column weight of the first range is greater than an average column weight of the second range, and an energy level corresponding to the first range is less than an energy level of the second range.

With reference to the first aspect, in some implementations of the first aspect, each of the at least two ranges includes one or more column weights, the at least two ranges include a third range, and column weights included in the third range change discontinuously and non-monotonically.

In this implementation, if column weights in a range change non-monotonically, degree distribution is freer, and a decoding threshold is better.

With reference to the first aspect, in some implementations of the first aspect, the column included in the base matrix corresponds to at least two subsets; and interleaving the first codeword sequence to obtain the second codeword sequence includes: interleaving bits in the first codeword sequence that correspond to a first subset of the at least two subsets, to obtain the second codeword sequence, where the first subset is an information column at a lowest degree in the base matrix, interleaved bits in the first subset are at the first A bit positions in descending order of energy levels in the QAM symbol, and A is a positive integer.

In this implementation, both a degree and whether a bit is an information bit are considered, to protect an information bit while achieving fast convergence. For example, the information bit is always mapped to a bit position at a high energy level, so that the information bit may be still correct even if an overall decoding error occurs.

With reference to the first aspect, in some implementations of the first aspect, A, a quantity *Nₘᵢₙ* of variable nodes at a lowest degree in the base matrix, and a length E of the first codeword sequence satisfy the following relational expression: $A = round \left(\frac{{N}_{min}}{E}⋅{Q}_{m}\right) ,$ where
round indicates a round-off function.

With reference to the first aspect, in some implementations of the first aspect, the column included in the base matrix corresponds to at least two subsets; and interleaving the first codeword sequence to obtain the second codeword sequence includes: interleaving a second subset of the at least two subsets to obtain the second codeword sequence, where the second subset is an information column at a highest degree in the at least two subsets, bits in the second subset correspond to the first A bit positions in ascending order of energy levels in the QAM symbol, and A is a positive integer.

In this implementation, both a degree and whether a bit is an information bit are considered, to protect an information bit while achieving fast convergence.

With reference to the first aspect, in some implementations of the first aspect, A, a quantity *Nₘₐₓ* of variable nodes at a highest degree in the base matrix, and a length E of the first codeword sequence satisfy the following relational expression: $A = round \left(\frac{{N}_{max}}{E}⋅{Q}_{m}\right) ,$ where
round indicates a round-off function.

With reference to the first aspect, in some implementations of the first aspect, the column included in the base matrix corresponds to at least two subsets; and interleaving the first codeword sequence to obtain the second codeword sequence includes: interleaving bits in a first subset of the at least two subsets to obtain the second codeword sequence, where the first subset is an information column at a lowest degree in the at least two subsets, and the bits in the first subset correspond to A bit positions at energy levels other than a lowest energy level in the QAM symbol.

In this implementation, both a degree and whether a bit is an information bit are considered, to protect an information bit while achieving fast convergence.

With reference to the first aspect, in some implementations of the first aspect, A, a quantity *Nₘᵢₙ* of variable nodes at a lowest degree in the base matrix, and a length E of the first codeword sequence satisfy the following relational expression: $A = round \left(\frac{E - {N}_{min}}{E}⋅{Q}_{m}\right) ,$ where
round indicates a round-off function.

With reference to the first aspect, in some implementations of the first aspect, the column included in the base matrix corresponds to at least two subsets; and interleaving the first codeword sequence to obtain the second codeword sequence includes: interleaving bits in a second subset of the at least two subsets to obtain the second codeword sequence, where the second subset is an information column at a highest degree in the at least two subsets, the bits in the second subset correspond to A bits at energy levels other than a highest energy level in the QAM symbol, and A is a positive integer.

In this implementation, both a degree and whether a bit is an information bit are considered, to protect an information bit while achieving fast convergence.

With reference to the first aspect, in some implementations of the first aspect, A, a quantity *Nₘₐₓ* of variable nodes at a highest degree in the base matrix, and a length E of the first codeword sequence satisfy the following relational expression: $A = round \left(\frac{E - {N}_{max}}{E}⋅{Q}_{m}\right) ,$ where
round indicates a round-off function.

With reference to the first aspect, in some implementations of the first aspect, the at least two ranges include a range [1], a range [4, 7], and a range [8, 11], where the range [8, 11] corresponds to the energy levels other than the highest energy level.

With reference to the first aspect, in some implementations of the first aspect, X=2, and the QAM symbol includes *Qₘ* bits. A bits of the *Qₘ* bits are from a first group of the X groups, and remaining *Qₘ*-A bits of the *Qₘ* bits are from a second group of the X groups. The A bits correspond to a 1^{st} range of the at least two ranges ranked in descending order of column weights, and the A bits are at the first A bit positions among the *Qₘ* bits ranked in ascending order of energy levels. A is a positive integer.

In this implementation, it is preferentially ensured that a node at a highest degree corresponds to a lowest energy level, to ensure performance of the LDPC at a high code rate (there is no extension check node, and there is a large quantity of high-degree nodes), and increase a decoding convergence speed.

With reference to the first aspect, in some implementations of the first aspect, a value of A is determined based on a quantity *Nₘₐₓ* of variable nodes at a highest degree in the base matrix and a length E of the first codeword sequence, and *Nₘₐₓ* and E are positive integers.

With reference to the first aspect, in some implementations of the first aspect, A, *Nₘₐₓ*, and E satisfy the following relationship: $A = round \left(\frac{{N}_{max}}{E}⋅{Q}_{m}\right) ,$ where
round indicates a round-off function.

With reference to the first aspect, in some implementations of the first aspect, X=2, and the QAM symbol includes *Qₘ* bits. A bits of the *Qₘ* bits are from a first group of the X groups, and remaining *Qₘ*-A bits of the *Qₘ* bits are from a second group of the X groups. The A bits correspond to a 1^{st} range of the at least two ranges ranked in ascending order of column weights, and the A bits are at the first A bit positions among the *Qₘ* bits ranked in descending order of energy levels. A is a positive integer.

In this implementation, it is preferentially ensured that a node at a lowest degree corresponds to a highest energy level, to ensure performance of the LDPC at a low code rate. There is a large quantity of extension check nodes and a large quantity of low-degree nodes, to increase a decoding convergence speed.

With reference to the first aspect, in some implementations of the first aspect, a value of A is determined based on a quantity *Nₘᵢₙ* of variable nodes at a lowest degree in the base matrix and a length E of the first codeword sequence, and *Nₘᵢₙ* and E are positive integers.

With reference to the first aspect, in some implementations of the first aspect, A, *Nₘᵢₙ*, and E satisfy the following relationship: $A = round \left(\frac{{N}_{min}}{E}⋅{Q}_{m}\right) ,$ where
round indicates a round-off function.

With reference to the first aspect, in some implementations of the first aspect, X=2, and the QAM symbol includes *Qₘ* bits. A bits of the *Qₘ* bits are from a first group of the X groups, and remaining *Qₘ*-A bits of the *Qₘ* bits are from a second group of the X groups. The A bits correspond to a 1^{st} range of the at least two ranges ranked in descending order of column weights, and the A bits are at A bit positions, among the *Qₘ* bits, that correspond to energy levels other than a highest energy level. A is a positive integer.

In this implementation, it is preferentially ensured that a highest degree does not correspond to a highest energy level, to ensure performance of the LDPC at a high code rate. There is no extension check node, and there is a large quantity of high-degree nodes, to increase a decoding convergence speed.

With reference to the first aspect, in some implementations of the first aspect, a value of A is determined based on a quantity *Nₘₐₓ* of variable nodes at a highest degree in the base matrix and a length E of the first codeword sequence, and *Nₘₐₓ* and E are positive integers.

With reference to the first aspect, in some implementations of the first aspect, A, *Nₘₐₓ*, and E satisfy the following relationship: $A = round \left(\frac{E - {N}_{max}}{E}⋅{Q}_{m}\right) ,$ where
round indicates a round-off function.

With reference to the first aspect, in some implementations of the first aspect, X=2, and the QAM symbol includes *Qₘ* bits. A bits of the *Qₘ* bits are from a first group of the X groups, and remaining *Qₘ*-A bits of the *Qₘ* bits are from a second group of the X groups. The A bits correspond to a 1^{st} range of the at least two ranges ranked in ascending order of column weights, and the A bits are at A bit positions, among the *Qₘ* bits, that correspond to energy levels other than a lowest energy level. A is a positive integer.

In this implementation, it is preferentially ensured that a lowest degree does not correspond to a lowest energy level, to ensure performance of the LDPC at a low code rate. There is a large quantity of extension check nodes and a large quantity of low-degree nodes, to increase a decoding convergence speed.

With reference to the first aspect, in some implementations of the first aspect, a value of A is determined based on a quantity *Nₘᵢₙ* of variable nodes at a lowest degree in the base matrix and a length E of the first codeword sequence, and *Nₘᵢₙ* and E are positive integers.

With reference to the first aspect, in some implementations of the first aspect, A, *Nₘᵢₙ*, and E satisfy the following relationship: $A = round \left(\frac{E - {N}_{min}}{E}⋅{Q}_{m}\right) ,$ where
round indicates a round-off function.

With reference to the first aspect, in some implementations of the first aspect, X=3, and the QAM symbol includes *Qₘ* bits. A bits of the *Qₘ* bits are from a first group of the X groups, other B bits, different from the A bits, of the *Qₘ* bits are from a second group of the X groups, and remaining *Qₘ*-A-B bits of the *Qₘ* bits are from a third group of the X groups. The A bits correspond to a 1^{st} range of the at least two ranges ranked in ascending order of column weights, and the B bits correspond to a 1^{st} range of the at least two ranges ranked in descending order of column weights. The A bits are at the first A bit positions among the *Qₘ* bits ranked in ascending order of energy, and the B bits are at the first B bit positions among the *Qₘ* bits ranked in descending order of energy levels. A and B are positive integers.

In this implementation, a larger quantity of groups in the first codeword sequence indicates that a low-degree node can more strictly correspond to a high energy level, and indicates a higher convergence speed.

With reference to the first aspect, in some implementations of the first aspect, A and B respectively satisfy the following relational expressions: $A = round \left(\frac{{N}_{max}}{E}⋅{Q}_{m}\right) ;$ and $B = round \left(\frac{{N}_{min}}{E}⋅{Q}_{m}\right) ,$ where
round indicates a round-off function, *Nₘₐₓ* indicates a quantity of variable nodes at a highest degree in the base matrix, *Nₘᵢₙ* indicates a quantity of variable nodes at a lowest degree in the base matrix, and E indicates a length of the first codeword sequence.

According to a second aspect, a de-interleaving method is provided. The method includes: obtaining a to-be-demodulated QAM symbol; demodulating the QAM symbol to obtain a first information sequence; de-interleaving the first information sequence to obtain a second information sequence, where the second information sequence corresponds to a base matrix of LDPC, column weights of columns included in the base matrix are related to energy levels of bit positions included in the QAM symbol, the second information sequence includes X groups, X is greater than or equal to 2, and X is a positive integer; and outputting the second information sequence.

For beneficial technical effects of the method in the second aspect, refer to the descriptions of the first aspect. Details are not described again.

In any one of the second aspect or implementations of the second aspect, a person skilled in the art should understand that bits (which may include an information bit and a check bit) sent by an encoding device are represented as LLR information on a decoding device. *Qₘ* pieces of LLR information carried in one QAM symbol may correspond to *Qₘ* bit positions included in the QAM symbol, and each piece of LLR information indicates a probability that a bit at a corresponding bit position is 0 or 1. The descriptions are also applicable to any one of the second aspect or the implementations of the second aspect. Details are not repeatedly described below.

The decoding device performs de-interleaving based on a correspondence that is between column weights of a base matrix and energy levels of bit positions included in a QAM symbol and that is the same as a correspondence on the encoding device side, to obtain a de-interleaved sequence. A de-interleaving process is not described in detail again. Further, the decoding device may decode the de-interleaved sequence.

According to a third aspect, a communication apparatus is provided. The communication apparatus has a function of implementing the method in the first aspect or the second aspect, or the method in any one of the possible implementations of the first aspect or the second aspect. The function may be implemented by hardware, or may be implemented by hardware executing corresponding software. The hardware or the software includes one or more units corresponding to the foregoing function.

According to a fourth aspect, this application provides a communication apparatus, including at least one processor. The at least one processor is coupled to at least one memory. The at least one memory is configured to store a computer program or instructions. The at least one processor is configured to invoke the computer program or the instructions from the at least one memory and run the computer program or the instructions, to enable the communication apparatus to perform the method in any one of the first aspect or the possible implementations of the first aspect or the method in any one of the second aspect or the possible implementations of the second aspect.

In an example, the communication apparatus in the third aspect or the fourth aspect may be an encoding apparatus or a decoding apparatus.

According to a fifth aspect, this application provides a communication apparatus, including a communication interface and a circuit. The communication interface is configured to receive a to-be-interleaved first codeword sequence, and input the first codeword sequence to the circuit. The circuit interleaves the first codeword sequence according to the interleaving method provided in this application, and maps an obtained second codeword sequence to a QAM symbol. The communication interface is further configured to output a modulated QAM symbol. For example, the communication apparatus in the fifth aspect is an encoding apparatus.

According to a sixth aspect, a communication apparatus is provided, including a communication interface and a circuit. The communication interface is configured to receive a to-be-demodulated QAM symbol, and input the QAM symbol to the circuit. The circuit demodulates the QAM symbol according to the de-interleaving method provided in this application, to obtain a first information sequence, and de-interleaves the first information sequence to obtain a second information sequence. The communication interface is further configured to output the second information sequence. Further, the circuit may be configured to determine an information bit based on the second information sequence, and the communication interface is further configured to output the information bit. For example, the communication apparatus in the sixth aspect is a decoding apparatus.

According to a seventh aspect, this application provides a computer-readable storage medium. The computer-readable storage medium stores computer program code or instructions. When the computer instructions are run on a computer, the method in any one of the first aspect or the possible implementations of the first aspect is implemented, or the method in any one of the second aspect or the possible implementations of the second aspect is implemented.

According to an eighth aspect, this application provides a computer program product. The computer program product includes computer program code or instructions. When the computer program code or the instructions are run on a computer, the method in any one of the first aspect or the possible implementations of the first aspect is implemented, or the method in any one of the second aspect or the possible implementations of the second aspect is implemented.

According to a ninth aspect, this application provides a wireless communication system, including the communication apparatus in any one of the third aspect to the sixth aspect, for example, an encoding apparatus and/or a decoding apparatus.

### BRIEF DESCRIPTION OF DRAWINGS

FIG. 1 shows an example of a base matrix of LDPC;
FIG. 2 is a diagram of capturing different matrix areas from a base matrix based on different code rates;
FIG. 3 shows an example of protecting information bits of LDPC;
FIG. 4 is a diagram of reading and writing in row-column interleaving;
FIG. 5 is a diagram of implementing row-column interleaving through memory concatenation;
FIG. 6 is a diagram of a system architecture to which embodiments of this application are applicable;
FIG. 7 is a schematic flowchart of an interleaving method and a de-interleaving method according to this application;
FIG. 8 is a diagram of a correspondence between energy levels and column weights of a base matrix according to this application;
FIG. 9 is a diagram of a scheme 1 according to this application;
FIG. 10 is a diagram of a scheme 2 according to this application;
FIG. 11 is a diagram of an example of a scheme 5 according to this application;
FIG. 12 is a diagram of an example of a scheme 7 according to this application;
FIG. 13 is a diagram of comparison between simulated BLER performance of an interleaving method according to this application;
FIG. 14 is a diagram of a structure of a communication apparatus according to this application;
FIG. 15 is a diagram of a structure of another communication apparatus according to this application; and
FIG. 16 is a diagram of a structure of still another communication apparatus according to this application.

### DESCRIPTION OF EMBODIMENTS

The following describes the technical solutions of this application with reference to the accompanying drawings.

For ease of understanding the technical solutions provided in this application, related technologies or concepts in embodiments of this application are briefly described.

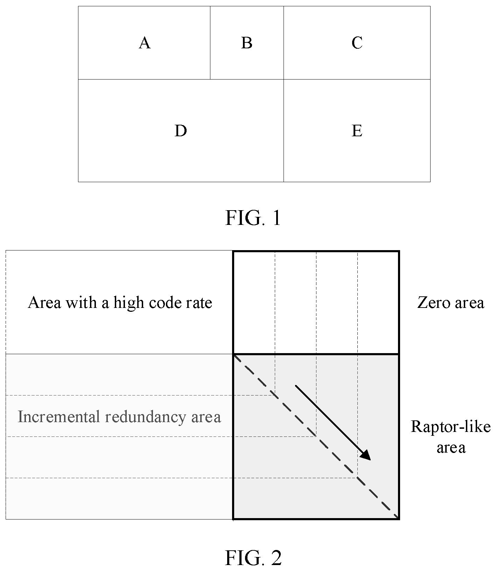

A low-density parity-check (low-density parity-check codes, LDPC) code is a channel coding scheme. LDPC of a mainstream application has a quasi-cyclic (quasi-cyclic, QC) structure. A tanner graph corresponding to a base matrix is referred to as a base graph (base graph, BG). A BG graph model of the QC-LDPC is *BG* =(*X*, *Y*, *F*), where *X* corresponds to a variable, *Y* corresponds to a check equation, and *F* is an edge relationship of the BG graph model. The BG graph model undergoes QC extension with an extension factor of *z_{c}*, to obtain a tanner graph: a bipartite graph *G*=(*V*, *C*, *E*), where *V* is a variable node, *C* is a check node, and *E* is an edge relationship of the bipartite graph. Variable nodes are in a one-to-one correspondence with codeword bits. Therefore, based on a variable node corresponding to a codeword bit, the codeword bit corresponds to a column weight of a matrix or a degree of the variable node in the tanner graph. A quantity of columns of a corresponding check matrix is as follows: *N* = |*V*| = *Z_{C}*|*X*|. A quantity of rows of the check matrix is as follows: *M* = |*C*| = *Z_{C}*|*Y*|. A quantity of non-zero elements of the check matrix is as follows: |*E*| = *Z*|*F*|. A base graph of LDPC in 5G includes a BG1 and a BG2, and has a common matrix structure. As shown in FIG. 1, a part A corresponds to an information column area with a high code rate, a part B corresponds to a core check area with a high code rate, a part C is a zero matrix, an area D is an incremental redundancy area of a matrix and corresponds to a low-code-rate matrix, and a part E is an incremental redundancy area and is of an identity matrix structure. A value of the base matrix is 0 or 1. The value 0 indicates an empty element, and the value 1 indicates an edge in the base graph or indicates that a corresponding check node is associated with a corresponding variable node.

FIG. 2 is a diagram of capturing different matrix areas from the base matrix based on different code rates. The area A and the area B form a matrix with a highest code rate. In a peak throughput scenario of 5G (for example, a code length is large, and a quantity of information bits in different scenarios may be 1000 to 2000 or greater than 8000), the BG1 alone is used for implementation. In the BG1, a quantity of columns in the area A is 22, a quantity of columns in the area B is 4, a quantity of punctured columns is 2, and a supported code rate is 22/(22+4-2)=11/12≈0.917, or a slightly higher code rate is supported through additional puncturing. The entire base matrix is designed based on a lowest code rate. When different code rates need to be supported, a part of areas in an upper left corner of the matrix are captured for use.

A 5G communication protocol supports a higher-order modulation scheme, for example, quadrature amplitude modulation (quadrature amplitude modulation, QAM). When a channel condition is good and a code rate is high, a transmitting side modulates a to-be-sent bit into a higher-order symbol, and sends the modulation symbol. A receiving side receives the modulation symbol, performs demodulation, and then performs decoding. In a QAM modulation scheme, one QAM symbol corresponds to a plurality of bits, and the plurality of bits are at different energy levels. For example, in QAM64, each symbol corresponds to *log*₂64 =6 bits and has three different energy levels. By default, a 1^{st} bit and a 2^{nd} bit correspond to an energy level 1 with highest energy, a 3^{rd} bit and a 4^{th} bit correspond to an energy level 2 with second highest energy, and a 5^{th} bit and a 6^{th} bit correspond to an energy level 3 with lowest energy. In QAM256, each symbol corresponds to *log*₂256 =8 bits and corresponds to four energy levels. A 1^{st} bit and a 2^{nd} bit correspond to an energy level 1, a 3^{rd} bit and a 4^{th} bit correspond to an energy level 2, a 5^{th} bit and a 6^{th} bit correspond to an energy level 3, and a 7^{th} bit and an 8^{th} bit correspond to an energy level 4. Energy gradually decreases from the energy level 1 to the energy level 4.

In the 5G communication protocol, a row-column interleaving method is currently used in the LDPC to interleave to-be-sent coded bits, to protect an information bit of the LDPC in the QAM modulation. For example, the information bit of the LDPC is mapped to a bit position at a high energy level in a QAM symbol if possible. In addition, the information bit may be an information bit or an information bit including a CRC check bit.

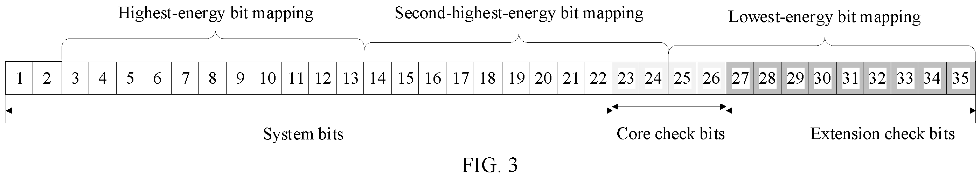

FIG. 3 shows an example of protecting information bits of LDPC. In this example, an information length of the LDPC is 8448, and a transmission length is 12672. This is LDPC with a code rate of 2/3. In a new radio (new radio, NR) coding protocol, BG1 coding is used, and a selected boost size is 384. Therefore, there are 22 information columns, and each information column includes 384 bits. It is specified in the NR protocol that the first two columns are to be punctured. Therefore, a quantity of check columns should be 12672/384-(22-2)=13, as shown in FIG. 3. Core check columns include four columns, and extension check columns include nine columns. The 13 columns serve as check columns of the LDPC. After the first two columns are punctured as not to be sent, 20 columns of system bits are still left. In combination with the 13 check columns, 33 columns are obtained as to-be-sent columns. Column indexes of the 33 to-be-sent columns are 3 to 35 shown in FIG. 3. 22 information columns/33 to-be-sent columns=2/3. This is a code rate of the LDPC.

It is specified in 5G that rate matching is to be performed after LDPC coding to obtain a to-be-sent bit sequence. The to-be-sent bit sequence usually needs to be interleaved to obtain a to-be-modulated bit sequence, and then modulation and transmission are performed.

A most commonly used interleaving mode is row-column interleaving. The row-column interleaving is to rearrange a bit sequence through row-based writing and column-based reading. It is assumed that the to-be-sent bit sequence obtained through rate matching is denoted as e, and the to-be-modulated bit sequence obtained through interleaving is denoted as a sequence f. If the row-column interleaving is used, a relationship between the sequence f and the sequence e may be as follows:

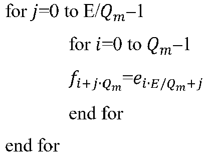

E indicates a transmission length, *Qₘ* indicates a quantity of bits included in each modulation symbol, *j* indicates an index of a QAM symbol, and *i* indicates an index of a bit position included in each QAM symbol. For a bit sequence with a transmission length of E, a quantity of QAM symbols is E/*Qₘ*. Therefore, a value of *j* ranges from 0 to E/*Qₘ*-1. If a quantity of bits included in one QAM symbol is *Qₘ*, a value of *i* ranges from 0 to *Qₘ*-1.

It can be learned from the relationship between the sequence e and the sequence f that, after bit interleaving is performed on a bit with a position index of *i* · E/*Qₘ* + *j* in the sequence e, a position index of the bit in the sequence f is *i* + *j* · *Qₘ*. Then bits in the sequence f are sequentially mapped to the QAM symbol.

The QAM64 is used as an example. *Qₘ* =6, corresponding to three energy levels. It can be learned from the relationship between the sequence f and the sequence e that a 3^{rd} column to a 13^{th} column of system bits are mapped to a 1^{st} bit position and a 2^{nd} bit position in each QAM symbol, that is, two bit positions with highest energy; a 14^{th} column to a 22^{nd} column of system bits and a 1^{st} column and a 2^{nd} column of extension check bits are mapped to a 3^{rd} bit position and a 4^{th} bit position in the QAM symbol, that is, two bit positions with second highest energy; and a 3^{rd} column and a 4^{th} column of core check and all columns of extension check bits are mapped to a 5^{th} bit position and a 6^{th} bit position in the QAM symbol, that is, two bit positions with lowest energy.

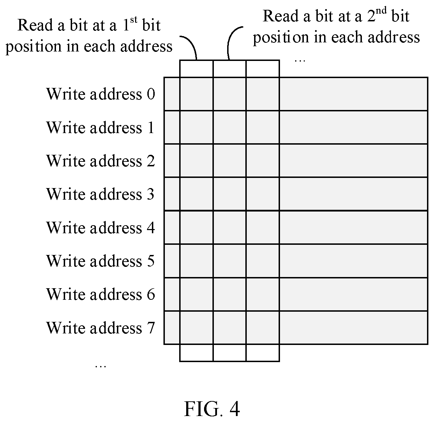

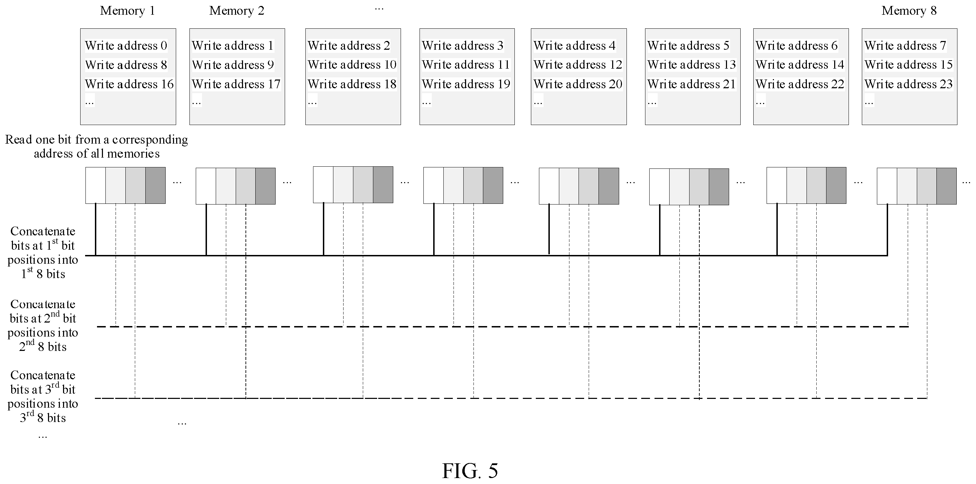

FIG. 4 is a diagram of reading and writing in row-column interleaving. As shown in FIG. 4, when interleaving is performed at a transmitting side, data is written row by row according to an order of an address 0, an address 1, an address 2, ..., and an address 7, and then is read by column. Specifically, a bit at a 1^{st} bit position in each address is read first, then a bit at a 2^{nd} bit position in each address is read, and so on. It can be learned that, when interleaving is performed at the transmitting side, 8 bits are written, and 1 bit is read. Implementation of this mode in a memory (memory) is complex. When de-interleaving is performed at a receiving side, eight log-likelihood ratios (log-likelihood ratio, LLR) are input, and one LLR is output. This suppresses a de-interleaving speed and further affects an overall decoding rate. A throughput bottleneck of a decoder may be transferred from decoding to de-interleaving, especially in an ultra-high-throughput scenario. In addition, a higher-order modulation scheme makes a de-interleaving process more complex and become a system bottleneck. To increase a de-interleaving speed, a large quantity of hardware resources need to be consumed. For example, to support 8-bit writing and 8-bit reading, a bit width of a memory (memory) needs to be extended, as shown in FIG. 5.

FIG. 5 is a diagram of implementing row-column interleaving through memory concatenation. For example, eight memories are concatenated together to implement 8-bit writing and 8-bit reading. However, this mode greatly increases hardware costs. For example, if 24 LLRs need to be read and written in parallel, assuming that each LLR needs a quantized bit width of 8 bits, a total bit width of 24 × 8 × 8 bits (namely, 1536 bits) is needed, leading to quite high hardware costs.

In view of the foregoing technical status quo, this application provides an interleaving method and a de-interleaving method in channel coding and a corresponding communication apparatus, to reduce complexity of bit interleaving while keeping interleaving performance basically unchanged.

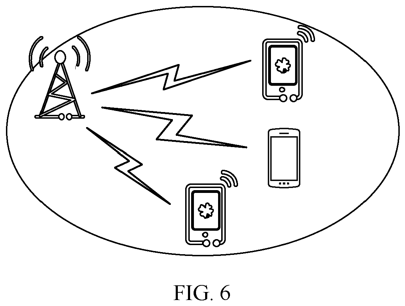

FIG. 6 is a diagram of a system architecture to which embodiments of this application are applicable. As shown in FIG. 6, the system architecture may include an encoding device and a decoding device. There may be one or more encoding devices, and there may be one or more decoding devices. For example, one of the encoding device and the decoding device may be a network device, and the other is a terminal device.

The terminal device in embodiments of this application includes various communication kits (communication kit, where the communication kit may include, for example, an antenna, a power supply template, a cable, and a wireless fidelity (wireless fidelity, Wi-Fi) module) with a wireless communication function, a handheld device, a vehicle-mounted device, or another processing device connected to a wireless modem, and may be specifically user equipment (user equipment, UE), a user, an access terminal, a subscriber unit, a subscriber station, a mobile station, a mobile console, a remote station, a remote terminal, a mobile device, a user terminal, a terminal, a wireless communication device, a user agent, a user apparatus, a wireless modem, a machine type communication device, or another processing device connected to a wireless modem. Alternatively, the terminal device may be a virtual reality (virtual reality, VR) terminal device, an augmented reality (augmented reality, AR) terminal device, a wireless terminal in industrial control (industrial control), a terminal in self-driving (self-driving), a terminal in telemedicine (remote medical), a terminal in a smart grid (smart grid), a terminal in transportation safety (transportation safety), a terminal in a smart city (smart city), a terminal in a smart home (smart home), a terminal device in a future communication network, or the like. Certainly, the terminal device in this application may alternatively be a chip, a modem, or a system-on-a-chip (system-on-a-chip, SoC) that is mainly responsible for a related communication function in a device, or a communication platform that may include a radio frequency (radio frequency, RF) part or the like.

The network device in embodiments of this application may include but is not limited to a next-generation base station (gNodeB, gNB) in a 5th generation (5th generation, 5G) communication system, a base station in a 6th generation (6th generation, 6G) mobile communication system, a base station in a future mobile communication system, an access point (access point, AP) in a wireless fidelity (wireless fidelity, Wi-Fi) system, a wireless relay node, a transmission point (transmission point, TP), a transmission reception point (transmission reception point, TRP), an evolved NodeB (evolved NodeB, eNB) in a long term evolution (long term evolution, LTE) system, a network device in a non-terrestrial network (non-terrestrial network, NTN) communication system, and the like. Alternatively, the network device may be one antenna panel or a group of (namely, a plurality of) antenna panels of a base station. Alternatively, the network device may be a network node included in a gNB or a TP, for example, a baseband processing unit (baseband unit, BBU), a central unit (central unit, CU), a distributed unit (distributed unit, DU), or a radio unit (radio unit, RU). Alternatively, the network device may be a device carrying a network-side function in a device-to-device (device-to-device, D2D) communication system, a machine-to-machine (machine-to-machine, M2M) communication system, an internet of things (Internet of Things, IoT), an internet of vehicles communication system, or another communication system, or the like. This is not limited.

In embodiments of this application, an apparatus for implementing a function of the terminal may be the terminal, or may be an apparatus that can support the terminal in implementing a corresponding function, for example, a chip (or chip system) or a chip. The apparatus may be installed in the terminal. In addition, an apparatus for implementing a function of the network device may be the network device, or may be an apparatus that can support the network device in implementing a corresponding function, for example, a chip (or chip system) or a circuit. The apparatus may be installed in the network device. Optionally, the chip system may include a chip, or include a chip and another discrete component.

In the system architecture shown in FIG. 6, in uplink communication, the encoding device is a terminal device, and the decoding device is a network device. In downlink communication, the encoding device is a network device, and the decoding device is a terminal device.

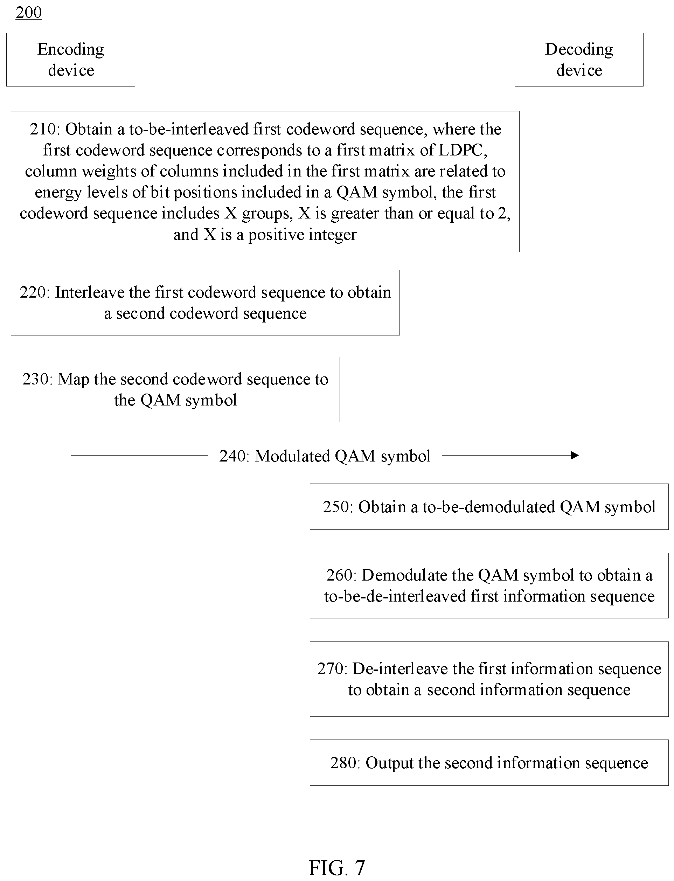

FIG. 7 is a schematic flowchart of an interleaving method and a de-interleaving method according to this application. S210 to S240 in the method 200 may be performed by an encoding device, or may be performed by an apparatus (for example, a chip, a chip system, or a circuit) used in an encoding device. S250 to S280 may be performed by a decoding device, or may be performed by an apparatus (for example, a chip, a chip system, or a circuit) used in a decoding device. The encoding device and the decoding device are separately used below as examples for description.

In addition, the technical solutions of this application may be applied to a QAM modulation scheme, and are also applicable to some other modulation schemes, for example, pulse amplitude modulation (pulse amplitude modulation, PAM) and phase shift keying (phase shift keying, PSK) modulation.

Generally, the technical solutions of this application provide a concept of "degree"-based interleaving that may indicate to incorporate a degree of a variable node when interleaving is performed on a to-be-interleaved codeword sequence. Based on the concept of degree-based interleaving, bits in a codeword sequence obtained through interleaving and energy levels of bit positions included in a QAM symbol satisfy a corresponding correspondence, to simplify hardware complexity of interleaving. In addition, interleaving performance of "degree"-based interleaving in this application is better than that of row-column interleaving.

S210: The encoding device obtains a to-be-interleaved first codeword sequence, where the first codeword sequence corresponds to a base matrix of LDPC, column weights of columns included in the base matrix are related to energy levels of bit positions included in a QAM symbol, the first codeword sequence includes X groups, X is greater than or equal to 2, and X is a positive integer.

In the channel coding field, a column weight of a matrix may be a quantity of 1s in a column of the matrix. In the LDPC, a column weight also represents a degree (degree, or referred to as degree) of a variable node. Therefore, a correspondence between a column weight and an energy level in embodiments is also a correspondence between a degree of a variable node and an energy level, and the two concepts are substantially the same.

In this embodiment of this application, the column weights of the columns included in the base matrix are related to the energy levels of the bit positions included in the QAM symbol. In an example, this may be specifically as follows: The column weights of the base matrix include at least two ranges, the at least two ranges include a first range and a second range, a minimum column weight in the first range is greater than a maximum column weight in the second range, and an energy level corresponding to the first range is less than an energy level corresponding to the second range. In another example, an average column weight of the first range is greater than an average column weight of the second range, and an energy level corresponding to the first range is less than an energy level corresponding to the second range. In terms of how to define a correspondence between a range (for example, the first range and/or the second range) and an energy level, the correspondence may be a preferential relationship, instead of an absolute relationship, of a correspondence between a range (for example, the first range and/or the second range) and an energy level. To be specific, the first range preferentially corresponds to a low energy level, and the second range preferentially corresponds to a high energy level. Therefore, in an actual case, in areas in which different code rates and matrices are used, a part of bit energy levels corresponding to the first range may be the same as those corresponding to the second range.

The first range and the second range are examples of any two of the at least two ranges. Therefore, in comparison, if a column weight in a range is large, an energy level corresponding to the range is low; and if a column weight in a range is small, an energy level corresponding to the range is high.

In this embodiment of this application, one range may include one or more column weights. This is not limited. Further, when one range includes two or more column weights, the column weights in the range may change monotonically or non-monotonically. This is not limited in this application. For example, the at least two ranges include a third range, and column weights included in the third range change discontinuously and non-monotonically. The third range is any one of the at least two ranges. For example, the third range may be the first range or the second range, or may be any other range of the at least two ranges. There may be one or more third ranges. This is not limited. If column weights in a range change monotonically, hardware implementation is simple, and a correspondence with energy levels is clearer. If column weights in a range change non-monotonically, degree distribution is freer, and a decoding threshold is better.

Therefore, the column weights of the columns included in the base matrix are numerically continuous or discontinuous. When the column weights of the columns included in the base matrix are discontinuous, after the columns included in the base matrix are divided into the at least two ranges, column weights included in any range may be continuous or discontinuous. In an example, the column weights of the columns included in the base matrix include several values: 1, 4, 7, 8, and 11. If the column weights are divided into three ranges, that is, a range [1], a range [4, 7], and a range [8, 11], the three ranges increase monotonically in ascending order of column weights. In the range [4, 7] and the range [8, 11], column weights are discontinuous.

In another example, a correspondence between the column weights of the columns included in the base matrix and the energy levels of the bit positions included in the QAM symbol may be as follows: An energy level corresponding to a 1^{st} column in the base matrix is higher than an energy level corresponding to a 2^{nd} column, where a column weight of the 1^{st} column is less than a column weight of the 2^{nd} column, and the 1^{st} column and the 2^{nd} column are examples of any two columns in the base matrix. That is, a column with a smaller column weight corresponds to a higher energy level, and a column with a larger column weight corresponds to a lower energy level.

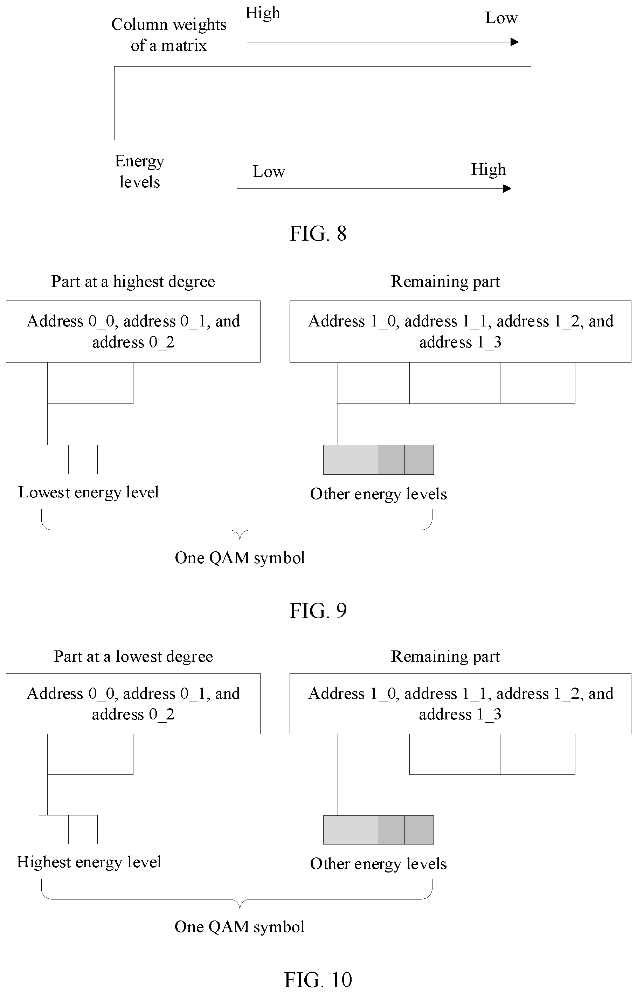

FIG. 8 is a diagram of a correspondence between energy levels and column weights of a base matrix according to this application. FIG. 8 shows only an example correspondence. To be specific, a column with a smaller column weight corresponds to a bit position at a lower energy level in the QAM symbol, and a column with a larger column weight corresponds to a bit position at a higher energy level in the QAM symbol. Therefore, bits in the first codeword sequence are reordered through interleaving to obtain a second codeword sequence, and then bits in the second codeword sequence are sequentially mapped to the QAM symbol, to implement "degree"-based interleaving. According to a simulation result of this application, the interleaving method for "degree"-based interleaving in this application can reduce hardware complexity of interleaving, and interleaving performance is also better than performance of row-column interleaving.

S220: The encoding device interleaves the first codeword sequence to obtain the second codeword sequence.

In this application, in an example, degree-based interleaving may be implemented through row-column interleaving. In an implementation, a codeword sequence (for example, the first codeword sequence) obtained through rate matching may be interleaved through cyclic block-level interleaving of quasi-cyclic (quasi-cyclic, QC)-LDPC. In this way, when a codeword sequence (for example, the second codeword sequence) obtained through interleaving is mapped to the QAM symbol, the correspondence shown in FIG. 8 exists between the bits in the second codeword sequence and the energy levels of the bit positions in the QAM symbol. Then degree-based interleaving effect is implemented based on row-column interleaving. In another implementation, a base matrix may be designed, to enable the correspondence shown in FIG. 8 to exist between bits in a codeword sequence obtained through encoding based on the base matrix and the energy levels of the bit positions in the QAM symbol. Then degree-based interleaving effect is implemented based on row-column interleaving.

S230: The encoding device maps the second codeword sequence to the QAM symbol.

S240: Output a modulated QAM symbol.

After completing interleaving and modulation, the encoding device outputs the modulated QAM symbol.

Correspondingly, the decoding device may perform the following S250 to S280.

S250: The decoding device obtains a to-be-demodulated QAM symbol.

S260: The decoding device demodulates the QAM symbol to obtain a to-be-de-interleaved first information sequence.

The first information sequence is a sequence of LLR information obtained through demodulation. Each piece of LLR information indicates a probability that a bit at a corresponding bit position is 0 or 1.

S270: The decoding device de-interleaves the first information sequence to obtain a second information sequence.

The second information sequence is a sequence of LLR information.

S280: The decoding device outputs the second information sequence.

S240 to S280 describe a process of demodulation and de-interleaving. In addition, the decoding device may further determine an information bit based on the second information sequence, to complete decoding.

In S250 to S280, demodulation and de-interleaving performed by the decoding device are respectively inverse processing of modulation and interleaving performed by the encoding device, and a principle is the same as that on the encoding device side. On the decoding device side, a correspondence between column weights of a base matrix and energy levels of bit positions included in a QAM symbol is the same as that on the encoding device side. Based on the method descriptions on the encoding device side, a person skilled in the art may understand how demodulation and de-interleaving are performed on the decoding device side. Details are not described again.

The correspondence between the base matrix and the energy levels shown in FIG. 8 is interleaving effect that needs to be achieved by degree-based interleaving in this application. Alternatively, the degree-based interleaving scheme shown in FIG. 8 may be simplified, to achieve a compromise between hardware complexity and interleaving performance. For example, a simplified interleaving scheme may further reduce hardware complexity, provided that interleaving performance is acceptable.

The following provides some simplified interleaving schemes of degree-based interleaving, for example, the following scheme 1 to scheme 4.

In the following examples, it is assumed that an I component and a Q component of the QAM symbol each include *q* bits. Therefore, each QAM symbol includes 2*q* bits, where *Qₘ* = 2*q*, and *q* is a positive integer. It should be noted that, in all implementations of this application, the I component and the Q component may be used separately, or symbols, at a same energy level, of the I component and the Q component may be bound by default for an operation. This is not limited.

### Scheme 1

A node at a highest degree corresponds to a lowest energy level.

Specifically, the bits in the first codeword sequence are divided into two groups, that is, X=2. The first A bits in ascending order of energy levels form one group (for example, referred to as a first group), and remaining bits form one group (for example, referred to as a second group). When the bits in the first codeword sequence are mapped to the QAM symbol, A bits with low energy among *Qₘ* bits corresponding to each QAM symbol are from the first group of the first codeword sequence, and remaining *Qₘ*-A bits are from the second group of the first codeword sequence, where A is a positive integer.

In an example, a value of A is determined based on a quantity *Nₘₐₓ* of variable nodes at a highest degree and a length E of the first codeword sequence. The length of the first codeword sequence is equal to a length of the second codeword sequence. In other words, a length of a codeword sequence remains unchanged before and after interleaving.

For example, A, *Nₘₐₓ*, and E satisfy the following relational expression (1): $A = round \left(\frac{{N}_{max}}{E}⋅{Q}_{m}\right)$ (1)

round indicates a round-off function. Optionally, round may alternatively be replaced with a ceil function or a floor function that are respectively used for rounding up and rounding down. The round function and the description that the round function may be replaced with the ceil function or the floor function are also applicable to other embodiments related to the round function below. Details are not repeatedly described below.

FIG. 9 is a diagram of the scheme 1 according to this application. An address 0_0 indicates a 0^{th} bit position of an address 0, an address 0_1 indicates a 1^{st} bit position of the address 0, and so on. Meanings of addresses in other embodiments below are also similar, and details are not described again. In this example, A=2, and *Qₘ*=6.

In an example, pseudocode of an interleaving process in the scheme 1 may be as follows:

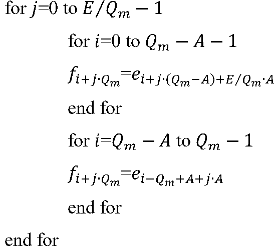

In the foregoing pseudocode, the sequence f is the second codeword sequence, and the sequence e is the first codeword sequence.

In addition, in all embodiments related to pseudocode in this application, it is assumed that the first codeword sequence is a sequence obtained through degree-based sorting, and degrees corresponding to sequence elements are in descending order. To be specific, a larger degree corresponds to an element with a smaller sequence index, and a smaller degree corresponds to an element with a larger sequence index. Details are not repeatedly described in the following embodiments.

### Scheme 2

A node at a lowest degree corresponds to a highest energy level.

Specifically, the bits in the first codeword sequence are divided into two groups, that is, X=2. The first A bits in descending order of energy levels form one group (referred to as a first group), and remaining bits form the other group (referred to as a second group). When the bits in the first codeword sequence are mapped to the QAM symbol, A bits among *Qₘ* bits corresponding to each QAM symbol are from the first group of the first codeword sequence, and remaining *Qₘ*-A bits are from the second group of the first codeword sequence.

In an example, a value of A is determined based on a quantity *Nₘᵢₙ* of variable nodes at a lowest degree and a length E of the first codeword sequence.

For example, A, *Nₘᵢₙ,* and E satisfy the following relational expression (2): $A = round \left(\frac{{N}_{min}}{E}⋅{Q}_{m}\right)$ (2)

round indicates a round-off function. Optionally, the round function may alternatively be replaced with a ceil function or a floor function.

FIG. 10 is a diagram of the scheme 2 according to this application. In this example, A=2, and *Qₘ=*6.

In an example, pseudocode of an interleaving process in the scheme 2 may be as follows:

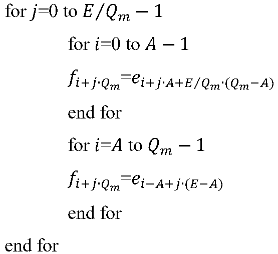

In the foregoing pseudocode, the sequence f is the second codeword sequence, and the sequence e is the first codeword sequence.

### Scheme 3

A node at a highest degree does not correspond to a highest energy level.

The bits in the first codeword sequence are divided into two groups. A bits corresponding to non-highest energy levels form one group (referred to as a first group), and remaining bits form the other group (referred to as a second group). When the bits in the first codeword sequence are mapped to the QAM symbol, bits, at the first A bit positions corresponding to energy levels in descending order, among *Qₘ* bits corresponding to each QAM symbol are from the second group of the first codeword sequence, and remaining *Qₘ*-A bits are from the first group of the first codeword sequence.

In an example, a value of A is determined based on a quantity *Nₘₐₓ* of variable nodes at a highest degree and a length E of the first codeword sequence.

For example, A, *Nₘₐₓ,* and E satisfy the following relational expression (3): $A = round \left(\frac{E - {N}_{max}}{E}⋅{Q}_{m}\right)$ (3)

round indicates a round-off function. Optionally, round may alternatively be a ceil function or a floor function.

In an example, pseudocode of an interleaving process in the scheme 3 may be as follows:

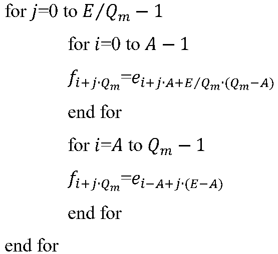

In the foregoing pseudocode, the sequence f is the second codeword sequence, and the sequence e is the first codeword sequence.

### Scheme 4

A node at a lowest degree does not correspond to a lowest energy level.

The bits in the first codeword sequence are divided into two groups. A bits corresponding to non-lowest energy levels form one group (referred to as a first group), and remaining bits form the other group (referred to as a second group). When the bits in the first codeword sequence are mapped to the QAM symbol, bits, at the first A bit positions corresponding to energy levels in ascending order, among *Qₘ* bits corresponding to each QAM symbol are from the first group of the first codeword sequence, and bits at remaining *Qₘ*-A bit positions are from the second group of the first codeword sequence.

In an example, A values are determined based on a quantity *Nₘᵢₙ* of variable nodes at a lowest degree and a length E of the first codeword sequence.

For example, A, *Nₘᵢₙ*, and E satisfy the following relational expression (4): $A = round \left(\frac{E - {N}_{min}}{E}⋅{Q}_{m}\right)$ (4)

In an example, pseudocode of an interleaving algorithm in the scheme 4 may be as follows:

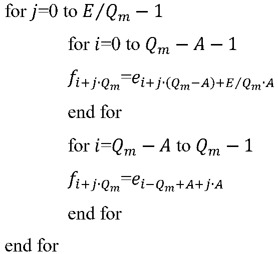

In the foregoing pseudocode, the sequence f is the second codeword sequence, and the sequence e is the first codeword sequence.

The foregoing scheme 1 to scheme 4 are examples in which the first codeword sequence is divided into two groups for QAM mapping, that is, X=2. In some other implementations, the bits in the first codeword sequence may alternatively be divided into more than two groups, for example, three or more groups, where X is greater than or equal to 3, as shown in the following scheme 5.

### Scheme 5

When the first codeword sequence is divided into three or more groups, X≥3. During mapping to the QAM symbol, this case may be combined with one or more of the foregoing scheme 1 to scheme 4. For example, a variable node with a highest degree corresponds to a lowest energy level (this case is combined with the scheme 1), or a variable node with a lowest degree corresponds to a highest energy level (this case is combined with the scheme 2), or both correspondences are satisfied, that is, this case is combined with both the scheme 1 and the scheme 2. On this basis, a person skilled in the art may understand that, when X≥3, this case may be combined with any one or more of the foregoing scheme 1 to scheme 4, to obtain a plurality of specific implementations. Details are not described in this specification. The following provides an example of the scheme 5.

In an example, the bits in the first codeword sequence are divided into three groups, and this case is combined with the foregoing scheme 1 and scheme 2. In this example, a bit corresponding to a variable node with a lowest degree (namely, a column with a smallest column weight, which may be one or more columns) forms one group (referred to as a first group), a bit corresponding to a variable node with a highest degree (namely, a column with a largest column weight, which may be one or more columns) forms one group (referred to as a second group), and a remaining bit forms one group (referred to as a third group). In addition, bits in the first group are mapped to the first A bit positions in descending order of energy levels in each QAM symbol, bits in the second group are mapped to the first B bit positions in ascending order of energy levels in each QAM symbol, and remaining bits in the first codeword sequence other than the first group and the second group are mapped to remaining *Qₘ*-A-B bit positions in each QAM symbol. A and B are positive integers. For A, refer to the calculation method for A in the relational expression (1) in the foregoing scheme 1. For B, refer to the calculation method for A in the relational expression (2) in the foregoing scheme 2.

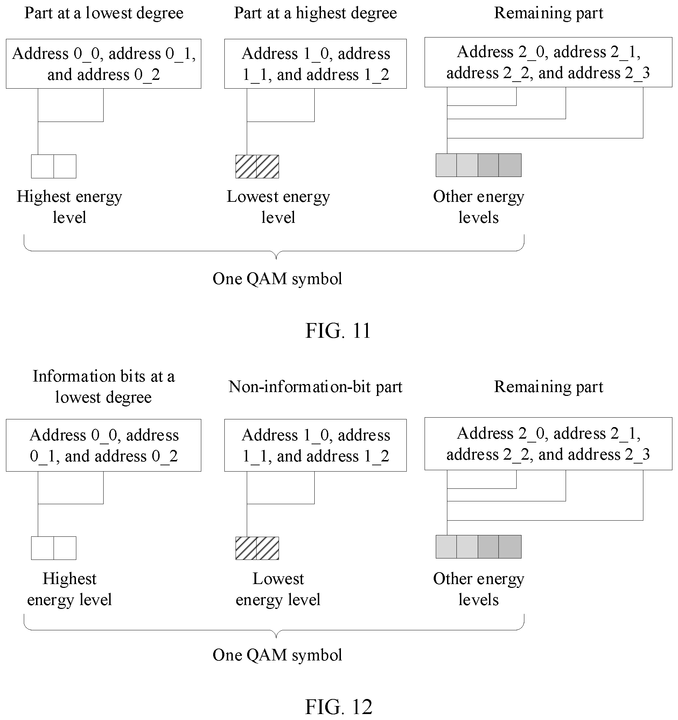

FIG. 11 is a diagram of an example of the scheme 5 according to this application. In this example, A=2, B=2, and *Qₘ*=8.

In an example, pseudocode of an interleaving algorithm in the scheme 5 may be as follows:

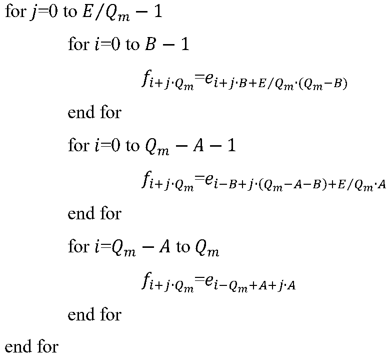

In the foregoing pseudocode, the sequence f is the second codeword sequence, and the sequence e is the first codeword sequence.

In another example, the bits in the first codeword sequence are divided into three groups, and this case is combined with the foregoing scheme 3 and scheme 4. In this example, a bit corresponding to a variable node at a highest degree in the first codeword sequence forms a first group, a bit corresponding to a variable node at a lowest degree forms a second group, and a remaining bit forms a third group. Bits in the first group are mapped to A bit positions in each QAM symbol other than the first A bit positions in ascending order of energy, and bits in the second group are mapped to B bit positions in each QAM symbol other than the first B bit positions in descending order of energy. For A, refer to the value of A in the relational expression (3) in the foregoing scheme 3. For B, refer to the calculation method for A in the relational expression (4) in the foregoing scheme 4.

A simulation result of this application indicates that a larger quantity of groups in the first codeword sequence, namely, a larger value of X, indicates better interleaving performance, but corresponding hardware complexity increases. Therefore, in actual use, a compromise may be made between the quantity X of groups and the hardware complexity based on a hardware condition and a scenario requirement.

It can be learned that, in the foregoing scheme 1 to scheme 5, the bits in the first codeword sequence are grouped based on a variable node at a highest degree or a variable node at a lowest degree (in other words, a maximum column weight or a minimum column weight of the base matrix), and satisfy a corresponding correspondence with the energy levels of the bit positions in the QAM symbol. With reference to a scheme 6, the following further provides an example in which degrees of variable nodes are divided into at least two ranges and then a correspondence with the energy levels of the bit positions in the QAM symbol is established based on the at least two ranges.

### Scheme 6

Based on degree distribution of variable nodes in the base matrix, degrees are divided into at least two ranges denoted as [*d*₁, *d*₂], [*d*₃, *d*₄], ... , *d*_{2*k*-1}, *d*_{2*k*}] , where *dₖ* changes monotonically with k, for example, *dₖ* increases or decreases monotonically with k. On this basis, this case is combined with the foregoing scheme 1 to scheme 5.

In an example, the degree distribution is divided into at least two ranges. If this case is combined with the scheme 1, a range [*d*_{2*k*-1}, *d*_{2*k*}] with a highest degree corresponds to a lowest energy level; if this case is combined with the scheme 2, a range [*d*₁, *d*₂] with a lowest degree corresponds to a highest energy level; if this case is combined with the scheme 3, a range [d_{2*k*-1}, *d*_{2*k*}] with a highest degree does not correspond to a highest energy level; or if this case is combined with the scheme 4, a range [*d*₁, d*₂*] with a lowest degree does not correspond to a lowest energy level. In addition, if this case is combined with the scheme 5, the at least two ranges may be specifically three ranges, and one or more of the correspondences in the scheme 1 to the scheme 4 are satisfied. For example, it is assumed that the at least two ranges include a first range, a second range, and a third range, degree distribution from the first range to the third range decreases monotonically, the first range corresponds to a lowest energy level, the third range corresponds to a highest energy level, and the second range corresponds to an energy level other than the lowest energy level and the highest energy level.

In an example, the degree distribution is divided into ranges [1], [4, 7], and [8, 11] in a monotonically increasing order. If this case is combined with the foregoing scheme 1, a column corresponding to the range [8, 11] corresponds to a lowest energy level. If this case is combined with the foregoing scheme 2, a column corresponding to the range [1] corresponds to a highest energy level.

It can be understood that there are many combinations in the foregoing scheme 6. Based on a design concept of this application, a person skilled in the art may know how to combine these schemes and whether these schemes can be combined. Details are not described herein.

In one or more embodiments of this application, the "degree" may be related to a code rate. Because the LDPC needs to support a flexible code rate, different areas of the base matrix may be captured as a matrix for encoding or decoding. Therefore, the matrix used for encoding or decoding may vary with different code rates, and a column weight of the matrix used for encoding or decoding may also vary with different code rates. The following provides some possible implementations.

In an implementation, the column weight described in some of the foregoing schemes may be a column weight of the entire base matrix, or a column weight of a matrix area, in the base matrix, that corresponds to a lowest code rate supported in a current communication scenario. For example, in a high-throughput scenario, a matrix area, in the base matrix, that corresponds to a high code rate is captured. In this case, the column weight may be a column weight corresponding to an area with a high code rate supported by the base matrix. For another example, in a scenario with a limited hardware condition, for example, a limited buffer (limited buffer, LBRM), the column weight may be a column weight corresponding to an area with a lowest code rate supported by the base matrix.

In another implementation, the column weight described in some of the foregoing schemes may be a column weight corresponding to a highest code rate supported by the base matrix. The highest code rate may be a highest code rate indicated by a modulation and coding scheme (modulation and coding scheme, MCS), or may be a code rate corresponding to a core area (the area A and the area B in FIG. 1) in the base matrix. Degrees of a matrix corresponding to the highest code rate are used for sorting, and it is considered that an extension check node is at a lowest degree. A reason lies in: A high-throughput peak scenario is a scenario with the highest code rate supported by the base matrix, and a fast convergence requirement of this part should be met to a maximum extent.

In an implementation, at least two indication sequences may be obtained on the encoding device side or the decoding device side, and each indication sequence corresponds to a code rate range or a row quantity range of a matrix. In actual use, a corresponding indication sequence is selected based on a sending code rate or a quantity of matrix rows used. The first codeword sequence is obtained by sorting, by column weight, a base matrix used in a code rate range corresponding to the at least two indication sequences. Optionally, the at least two code rate ranges include a code rate corresponding to a core matrix of the base matrix.

### Scheme 7

The columns of the base matrix may be divided into at least two subsets, and both "degrees" of bits in at least one of the at least two subsets and whether the bits are information bits need to be considered during mapping to the energy levels in the QAM symbol. In other words, when QAM mapping is performed on the bits in the at least one subset, both information bit protection and the "degree"-based interleaving in this application are considered.

In an example, the columns of the base matrix may be divided into three subsets. A first subset is an information column, a second subset is a core check column, and a third subset is an extension check column. In another example, the columns of the base matrix may be divided into two subsets. A first subset is an information column and a core check column, and a second subset is an extension check column.

The division into the at least two subsets may be combined with any one of the foregoing scheme 1 to scheme 4. The division may alternatively be combined with a plurality of schemes of the scheme 1 to the scheme 4 without a contradiction. The following provides some examples.

In an example, energy level mapping for bits in the second subset is combined with the scheme 1, and information bit protection is also considered. For example, an information column at a highest degree in the second subset corresponds to the first A bit positions in ascending order of energy levels in the QAM symbol, where A is a positive integer.

A satisfies the following relational expression: $A = round \left(\frac{{N}_{max}}{E}⋅{Q}_{m}\right)$ (7-1)

In another example, energy level mapping for bits in the first subset is combined with the scheme 2, and information bit protection is also considered. For example, an information column at a lowest degree in the first subset corresponds to the first A bit positions in descending order of energy levels in the QAM symbol.

A satisfies the following relational expression: $A = round \left(\frac{{N}_{min}}{E}⋅{Q}_{m}\right)$ (7-2)

In still another example, energy level mapping for bits in the second subset is combined with the scheme 3, and whether the bits are information bits is also considered. For example, an information column at a highest degree in the second subset corresponds to A bit positions corresponding to energy levels in the QAM symbol other than a highest energy level.

A satisfies the following relational expression: $A = round \left(\frac{E - {N}_{max}}{E}⋅{Q}_{m}\right)$ (7-3)

In still another example, energy level mapping for bits in the first subset is combined with the scheme 4, and information bit protection is also considered. For example, an information column with a lowest degree in the first subset corresponds to A bit positions corresponding to energy levels in the QAM symbol other than a lowest energy level.

A satisfies the following relational expression: $A = round \left(\frac{E - {N}_{min}}{E}⋅{Q}_{m}\right)$ (7-4)

For descriptions of the parameters in the relational expressions in the scheme 7, refer to the foregoing descriptions. Details are not repeatedly described.

In still another example, the bit positions included in the QAM symbol are divided into three groups based on energy. Non-information bits correspond to the first A bit positions in ascending order of energy levels. The first B bit positions, in descending order of energy levels, that correspond to information bits at a lowest degree form one group. Other bits are at remaining *Qₘ* - *A* - B bit positions in the QAM symbol.

In this example, A may be determined based on a code rate r, and B is determined based on a length E of the first codeword sequence and a quantity *Nₘᵢₙ* of variable nodes at a lowest degree among information bits.

For example, A or B satisfies the following relational expression (7-5): $A = round \left(\left(1-r\right)⋅{Q}_{m}\right)$ $B = round \left(\frac{{N}_{min}}{E}⋅{Q}_{m}\right)$

round indicates a round-off function. Optionally, the round function may alternatively be replaced with a ceil function or a floor function.

FIG. 12 is a diagram of the scheme 7 according to this application. In this example, A=2, B=2, and *Qₘ*=8.

In an example, pseudocode of an interleaving algorithm in the scheme 7 may be as follows:

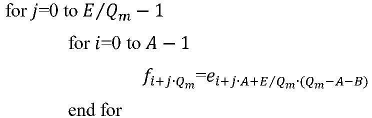

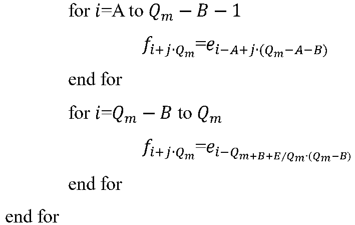

In the foregoing pseudocode, the sequence f is the second codeword sequence, and the sequence e is the first codeword sequence.

An advantage of the scheme 7 lies in that an information bit can be protected with fast convergence achieved. To be specific, the information bit is always mapped to a bit position at a highest energy level in the QAM symbol, so that the information bit is still correctly decoded even if a transmitted codeword encounters an overall decoding error, to increase a probability of successfully decoding the information bit.

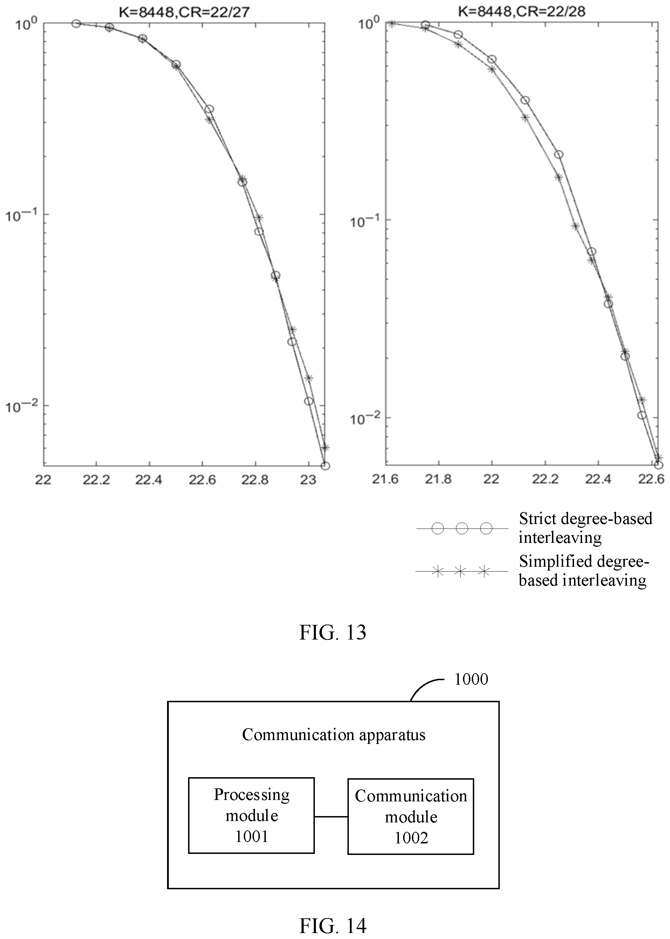

FIG. 13 is a diagram of comparison between simulated block error rate (block error rate, BLER) performance of the interleaving method according to this application. In FIG. 13, a horizontal coordinate indicates a signal-to-noise ratio (signal-to-noise ratio, SNR), and a vertical coordinate indicates a block error rate BLER. A code length is 8448, and a quantity of iterations is 4. It can be learned that, when complexity is greatly reduced, performance of the simplified interleaving scheme in this application is quite close to that of strict degree-based interleaving. A BLER-SNR slope has a slight loss, but a difference in overall performance is quite small. It can be learned that, in the interleaving method provided in this application, hardware complexity is lower when performance of the degree-based interleaving is kept basically unchanged.

The foregoing describes in detail the interleaving method or the de-interleaving method provided in this application. The following describes a communication apparatus provided in this application.

As shown in FIG. 14, this application provides a communication apparatus 1000.

The communication apparatus 1000 may be an encoding device, or may be an apparatus that is used in an encoding device and that can implement a corresponding function of the encoding device in the method embodiments of this application, for example, a chip, a chip system, or a circuit. Alternatively, the communication apparatus 1000 may be a decoding device, or may be an apparatus that is used in a decoding device and that can implement a corresponding function of the decoding device in the method embodiments of this application, for example, a chip, a chip system, or a circuit.

Optionally, the communication apparatus 1000 includes a processing module 1001. The processing module may be a processor, a processing board, a processing unit, a processing apparatus, or the like. When the communication apparatus 1000 is the encoding device or the apparatus used in the encoding device, the processing module 1001 is configured to interleave a to-be-interleaved first codeword sequence to obtain a second codeword sequence, and map the second codeword sequence to a QAM symbol. For a specific process, refer to the detailed descriptions of the interleaving process in the method embodiments. Details are not described herein again. When the communication apparatus 1000 is the decoding device or the apparatus used in the decoding device, the processing module 1001 is configured to demodulate a to-be-demodulated QAM symbol to obtain a first information sequence, and de-interleave the first information sequence to obtain a second information sequence. For a specific process, refer to the descriptions of the de-interleaving process in the method embodiments. Details are not described herein again.

Optionally, the communication apparatus 1000 further includes a communication module 1002. The communication module may also be referred to as a transceiver module, a transceiver, a transceiver device, a transceiver apparatus, or the like, and is configured to perform a receiving (or input) operation and/or a sending (or output) operation. For example, when the communication apparatus 1000 is the encoding device or the apparatus used in the encoding device, the communication module 1002 may be configured to obtain the to-be-interleaved first codeword sequence and output a modulated QAM symbol. When the communication apparatus 1000 is the decoding device or the apparatus used in the decoding device, the communication module 1002 may be configured to obtain the to-be-demodulated QAM symbol and output the second information sequence.

In some embodiments, the communication module and/or the processing module may be implemented by using a virtual module. For example, the processing module may be implemented by using a software functional unit or a virtual apparatus, and the communication module may be implemented by using a software function or a virtual apparatus. Alternatively, the processing module or the communication module may be implemented by using a physical apparatus. For example, if the apparatus is implemented by using a chip/circuit (for example, an integrated circuit or a logic circuit), the communication module may be an input/output circuit and/or a communication interface, and performs an input operation (corresponding to the foregoing receiving operation) and an output operation (corresponding to the foregoing sending operation); and the processing module is an integrated processor, a microprocessor, or a circuit (for example, an integrated circuit or a logic circuit).

In this application, division into the modules is an example, and is merely logical function division. During actual implementation, another division manner may be used. In addition, functional modules in examples of this application may be integrated into one processor, or each of the modules may exist alone physically, or two or more modules may be integrated into one module. The integrated module may be implemented in a form of hardware, or may be implemented in a form of a software functional module.

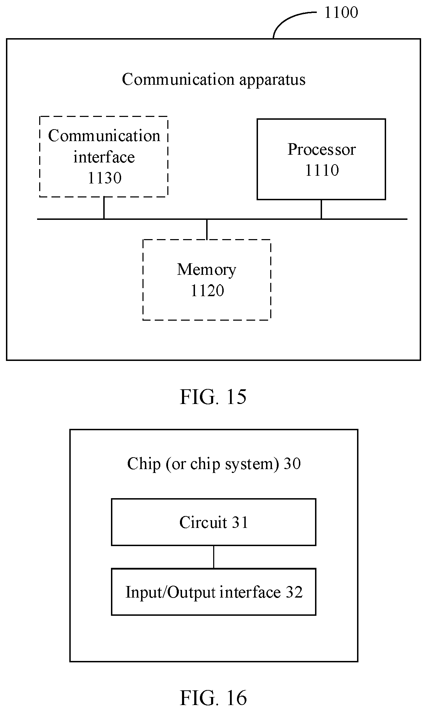

As shown in FIG. 15, this application further provides a communication apparatus 1100. The communication apparatus 1100 includes at least one processor 1110, to implement the functions of the encoding device or the decoding device described in the foregoing method embodiments.

Optionally, the processor 1110 is coupled to a memory. The memory may be located in the communication apparatus, or the memory may be integrated with the processor, or the memory may be located outside the communication apparatus. The communication apparatus 1100 may further include at least one memory 1120. The memory 1120 stores a computer program, instructions, data, or the like necessary for implementing any one of the foregoing method embodiments. The processor 1110 may execute the computer program, the instructions, the data, or the like stored in the memory 1120, to perform the interleaving method or the de-interleaving method in any one of the foregoing embodiments.

Optionally, the communication apparatus 1100 may further include a communication interface 1130, and the communication apparatus 1100 may exchange information with another device through the communication interface 1130. For example, the communication interface 1130 may be a transceiver, a circuit, a bus, a module, a pin, or an interface of another type.

The coupling in this application is an indirect coupling or a communication connection between apparatuses, units, or modules, may be in an electrical form, a mechanical form, or another form, and is used for information exchange between the apparatuses, the units, or the modules. The processor 1110 may operate cooperatively with the memory 1120 and the communication interface 1130. A specific connection medium between the processor 1110, the memory 1120, and the communication interface 1130 is not limited in this application.

As shown in FIG. 16, this application further provides a chip (or chip system). The chip (or chip system) 30 may include a circuit 31 and an input/output interface 32. The circuit 31 may be a logic circuit, an integrated circuit, or the like. The input/output interface 32 may alternatively be an input/output circuit or an interface circuit, and may input information (or referred to as receiving information) and output information (or referred to as sending information). Optionally, the chip system may include a chip, or may include a chip and another discrete component. The chip 30 may be configured to perform the method performed by the encoding device or the decoding device in embodiments of this application.

In addition, this application further provides a computer-readable storage medium. The computer-readable storage medium stores computer instructions. When the computer instructions are run on a computer, the operations and/or the processing performed by the encoding device or the decoding device in the method embodiments of this application are/is performed.

This application further provides a computer program product. The computer program product includes computer program code or instructions. When the computer program code or the instructions are run on a computer, the operations and/or the procedures performed by the encoding device or the decoding device in the method embodiments of this application are/is performed.

In addition, this application further provides a chip. The chip includes a processor. A memory configured to store a computer program is disposed separately from the chip. The processor is configured to execute the computer program stored in the memory, to perform the operations and/or the processing performed by the encoding device or the decoding device in any one of the method embodiments.

Further, the chip may include a communication interface. The communication interface may be an input/output interface, an interface circuit, or the like. Further, the chip may include a memory.

This application provides a communication system, including an encoding apparatus and a decoding apparatus. The encoding apparatus is configured to implement S210 to S240, and the decoding apparatus is configured to implement S250 to S280. In some embodiments, the encoding apparatus is the communication apparatus serving as the encoding apparatus in FIG. 14 or FIG. 15, or the chip for implementing the encoding apparatus in FIG. 16.

In embodiments of this application, "a plurality of" includes two or more.

In this application, the processor may be a general-purpose processor, a digital signal processor, an applicationspecific integrated circuit, a field programmable gate array or another programmable logic device, a discrete gate or transistor logic device, or a discrete hardware component, and may implement or perform the methods, steps, and logical block diagrams disclosed in this application. The general-purpose processor may be a microprocessor, any conventional processor, or the like. The steps of the methods disclosed with reference to this application may be directly performed by a hardware processor, or may be performed by hardware in a processor in combination with a software module.

The memory may be a nonvolatile memory, for example, a hard disk drive (hard disk drive, HDD) or a solid-state drive (solid-state drive, SSD), or may be a volatile memory (volatile memory), for example, a random access memory (random access memory, RAM). The memory is any other medium that can carry or store expected program code in a form of an instruction or a data structure and that can be accessed by a computer, but is not limited thereto. The memory in this application may alternatively be a circuit or any other apparatus that can implement a storage function, and is configured to store program instructions and/or data.

All or some of the technical solutions provided in this application may be implemented by software, hardware, firmware, or any combination thereof. When the technical solutions are implemented by software, all or some of the technical solutions may be implemented in a form of a computer program product. The computer program product includes one or more computer instructions. When the computer program instructions are loaded and executed on a computer, all or some of the processes or the functions according to this application are generated. The computer may be a general-purpose computer, a dedicated computer, a computer network, a terminal device, an access network device, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible to a computer, or a data storage device, for example, a server or a data center, integrating one or more usable media. The usable medium may be a magnetic medium (for example, a floppy disk, a hard disk drive, or a magnetic tape), an optical medium (for example, a digital video disc (digital video disc, DVD)), a semiconductor medium, or the like.

In this application, without a logical contradiction, mutual reference may be made between examples. For example, mutual reference may be made between methods and/or terms in the method embodiments, mutual reference may be made between functions and/or terms in the apparatus embodiments, and mutual reference may be made between functions and/or terms in the apparatus examples and the method examples.

A person of ordinary skill in the art may be aware that units and algorithm steps in examples described with reference to embodiments disclosed in this specification can be implemented by electronic hardware or a combination of computer software and electronic hardware. Whether the functions are performed by hardware or software depends on particular applications and design constraints of the technical solutions. A person skilled in the art may use different methods to implement the described functions for each particular application. However, it should not be considered that the implementation goes beyond the scope of this application.

It can be clearly understood by a person skilled in the art that, for ease and brevity of description, for detailed working processes of the foregoing systems, apparatuses, and units, reference may be made to corresponding processes in the foregoing method embodiments. Details are not described herein again.

In the several embodiments provided in this application, it should be understood that the disclosed systems, apparatuses, and methods may be implemented in other manners. For example, the described apparatus embodiments are merely examples. For example, division into the units is merely logical function division. During actual implementation, another division manner may be used. For example, a plurality of units or components may be combined or integrated into another system, or some features may be ignored or not performed. In addition, the shown or discussed mutual couplings, direct couplings, or communication connections may be implemented through some interfaces. The indirect couplings or communication connections between the apparatuses or units may be implemented in an electrical form, a mechanical form, or other forms.

The units described as separate components may or may not be physically separated, and components shown as units may or may not be physical units, to be specific, may be located in one place, or may be distributed on a plurality of network units. Some or all of the units may be selected according to actual requirements to achieve the objectives of the solutions of embodiments.

In addition, functional units in embodiments of this application may be integrated into one processing unit, or each unit may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods in embodiments of this application. The storage medium includes any medium that can store program code, for example, a USB flash drive, a removable hard disk drive, a read-only memory (Read-Only Memory, ROM), a random access memory (Random Access Memory, RAM), a magnetic disk, or a compact disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An interleaving method, comprising:
obtaining a to-be-interleaved first codeword sequence, wherein the first codeword sequence corresponds to a base matrix of a low-density parity-check LDPC code, column weights of columns comprised in the base matrix are related to energy levels of bit positions comprised in a quadrature amplitude modulation QAM symbol, the first codeword sequence comprises X groups, X is greater than or equal to 2, and X is a positive integer;
interleaving the first codeword sequence to obtain a second codeword sequence;
mapping the second codeword sequence to the QAM symbol; and
outputting a modulated QAM symbol.

2. The method according to claim 1, wherein that the column weights of the base matrix are related to the energy levels of the bit positions comprised in the QAM symbol comprises:
the column weights of the base matrix comprise at least two ranges, a minimum column weight in a first range of the at least two ranges is greater than a maximum column weight in a second range of the at least two ranges, and an energy level corresponding to the first range is less than an energy level corresponding to the second range.

3. The method according to claim 2, wherein each of the at least two ranges comprises one or more column weights, the at least two ranges comprise a third range, and column weights comprised in the third range change discontinuously and non-monotonically.

4. The method according to any one of claims 1 to 3, wherein the column comprised in the base matrix corresponds to at least two subsets; and
interleaving the first codeword sequence to obtain the second codeword sequence comprises:
interleaving bits in the first codeword sequence that correspond to a first subset of the at least two subsets, to obtain the second codeword sequence, wherein the first subset is an information column at a lowest degree in the base matrix, bits in the first subset correspond to the first A bit positions in descending order of energy levels in the QAM symbol, and A is a positive integer.

5. The method according to claim 4, wherein A, a quantity *Nₘᵢₙ* of variable nodes at a lowest degree in the base matrix, and a length E of the first codeword sequence satisfy the following relational expression: $A = round \left(\frac{{N}_{min}}{E}⋅{Q}_{m}\right) ,$ wherein
round indicates a round-off function.

6. The method according to any one of claims 1 to 5, wherein the column comprised in the base matrix corresponds to at least two subsets; and
interleaving the first codeword sequence to obtain the second codeword sequence comprises:
interleaving a second subset of the at least two subsets to obtain the second codeword sequence, wherein the second subset is an information column at a highest degree in the at least two subsets, bits in the second subset correspond to the first A bit positions in ascending order of energy levels in the QAM symbol, and A is a positive integer.

7. The method according to claim 6, wherein A, a quantity *Nₘₐₓ* of variable nodes at a highest degree in the base matrix, and a length E of the first codeword sequence satisfy the following relational expression: $A = round \left(\frac{{N}_{max}}{E}⋅{Q}_{m}\right) ,$ wherein
round indicates a round-off function.

8. The method according to any one of claims 1 to 3, wherein the column comprised in the base matrix corresponds to at least two subsets; and
interleaving the first codeword sequence to obtain the second codeword sequence comprises:
interleaving bits in a first subset of the at least two subsets to obtain the second codeword sequence, wherein the first subset is an information column at a lowest degree in the at least two subsets, and the bits in the first subset correspond to A bit positions at energy levels other than a lowest energy level in the QAM symbol.

9. The method according to claim 8, wherein A, a quantity *Nₘᵢₙ* of variable nodes at a lowest degree in the base matrix, and a length E of the first codeword sequence satisfy the following relational expression: $A = round \left(\frac{E - {N}_{min}}{E}⋅{Q}_{m}\right) ,$ wherein
round indicates a round-off function.

10. The method according to any one of claims 1 to 3, wherein the column comprised in the base matrix corresponds to at least two subsets; and
interleaving the first codeword sequence to obtain the second codeword sequence comprises:
interleaving bits in a second subset of the at least two subsets to obtain the second codeword sequence, wherein the second subset is an information column at a highest degree in the at least two subsets, the bits in the second subset correspond to A bits at energy levels other than a highest energy level in the QAM symbol, and A is a positive integer.

11. The method according to claim 10, wherein A, a quantity *Nₘₐₓ* of variable nodes at a highest degree in the base matrix, and a length E of the first codeword sequence satisfy the following relational expression: $A = round \left(\frac{E - {N}_{max}}{E}⋅{Q}_{m}\right) ,$ wherein
round indicates a round-off function.

12. The method according to any one of claims 1 to 3, wherein X=2, and the QAM symbol comprises *Qₘ* bits; and
A bits of the *Qₘ* bits are from a first group of the X groups, remaining *Qₘ*-A bits of the *Qₘ* bits are from a second group of the X groups, the A bits correspond to a 1^{st} range of the at least two ranges ranked in descending order of column weights, the A bits are at the first A bit positions among the *Qₘ* bits ranked in ascending order of energy levels, and A is a positive integer.

13. The method according to claim 12, wherein a value of A is determined based on a quantity *Nₘₐₓ* of variable nodes at a highest degree in the base matrix and a length E of the first codeword sequence, and *Nₘₐₓ* and E are positive integers.

14. The method according to claim 13, wherein A, *Nₘₐₓ*, and E satisfy the following relationship: $A = round \left(\frac{{N}_{max}}{E}⋅{Q}_{m}\right) ,$ wherein
round indicates a round-off function.

15. The method according to any one of claims 1 to 3, wherein X=2, and the QAM symbol comprises *Qₘ* bits; and
A bits of the *Qₘ* bits are from a first group of the X groups, remaining *Qₘ*-A bits of the *Qₘ* bits are from a second group of the X groups, the A bits correspond to a 1^{st} range of the at least two ranges ranked in ascending order of column weights, the A bits are at the first A bit positions among the *Qₘ* bits ranked in descending order of energy levels, and A is a positive integer.

16. The method according to claim 15, wherein a value of A is determined based on a quantity *Nₘᵢₙ* of variable nodes at a lowest degree in the base matrix and a length E of the first codeword sequence, and *Nₘᵢₙ* and E are positive integers.

17. The method according to claim 16, wherein A, *Nₘᵢₙ*, and E satisfy the following relationship: $A = round \left(\frac{{N}_{min}}{E}⋅{Q}_{m}\right) ,$ wherein
round indicates a round-off function.

18. The method according to any one of claims 1 to 3, wherein X=2, and the QAM symbol comprises *Qₘ* bits; and
A bits of the *Qₘ* bits are from a first group of the X groups, remaining *Qₘ*-A bits of the *Qₘ* bits are from a second group of the X groups, the A bits correspond to a 1^{st} range of the at least two ranges ranked in descending order of column weights, the A bits are at A bit positions, among the *Qₘ* bits, that correspond to energy levels other than a highest energy level, and A is a positive integer.

19. The method according to claim 18, wherein a value of A is determined based on a quantity *Nₘₐₓ* of variable nodes at a highest degree in the base matrix and a length E of the first codeword sequence, and *Nₘₐₓ* and E are positive integers.

20. The method according to claim 19, wherein , *Nₘₐₓ,* and E satisfy the following relationship: $A = round \left(\frac{E - {N}_{max}}{E}⋅{Q}_{m}\right) ,$ wherein
round indicates a round-off function.

21. The method according to any one of claims 1 to 3, wherein X=2, and the QAM symbol comprises *Qₘ* bits; and
A bits of the *Qₘ* bits are from a first group of the X groups, remaining *Qₘ*-A bits of the *Qₘ* bits are from a second group of the X groups, the A bits correspond to a 1^{st} range of the at least two ranges ranked in ascending order of column weights, the A bits are at A bit positions, among the *Qₘ* bits, that correspond to energy levels other than a lowest energy level, and A is a positive integer.

22. The method according to claim 21, wherein a value of A is determined based on a quantity *Nₘᵢₙ* of variable nodes at a lowest degree in the base matrix and a length E of the first codeword sequence, and *Nₘᵢₙ* and E are positive integers.

23. The method according to claim 22, wherein A, *Nₘᵢₙ*, and E satisfy the following relationship: $A = round \left(\frac{E - {N}_{min}}{E}⋅{Q}_{m}\right) ,$ wherein
round indicates a round-off function.

24. The method according to any one of claims 1 to 3, wherein X=3, and the QAM symbol comprises *Qₘ* bits; and
bits at the first A bit positions among the *Qₘ* bits ranked in ascending order of energy levels are from a first group of the X groups, bits at the first B bit positions among the *Qₘ* bits ranked in descending order of energy levels are from a second group of the X groups, and remaining *Qₘ*-A-B bits of the *Qₘ* bits are from a third group of the X groups, wherein the A bits correspond to a 1^{st} range of the at least two ranges ranked in descending order of column weights, and the B bits correspond to a 1^{st} range of the at least two ranges ranked in ascending order of column weights.

25. The method according to claim 24, wherein A and B respectively satisfy the following relational expressions: $A = round \left(\frac{{N}_{max}}{E}⋅{Q}_{m}\right) ;$ and $B = round \left(\frac{{N}_{min}}{E}⋅{Q}_{m}\right) ,$ wherein
round indicates a round-off function, *Nₘₐₓ* indicates a quantity of variable nodes at a highest degree in the base matrix, *Nₘᵢₙ* indicates a quantity of variable nodes at a lowest degree in the base matrix, and E indicates a length of the first codeword sequence.

26. A communication apparatus, comprising:
a communication module, configured to obtain a to-be-interleaved first codeword sequence, wherein the first codeword sequence corresponds to a base matrix of LDPC, column weights of columns comprised in the base matrix are related to energy levels of bit positions comprised in a QAM symbol, the first codeword sequence comprises X groups, X is greater than or equal to 2, and X is a positive integer; and
a processing module, configured to:
interleave the first codeword sequence to obtain a second codeword sequence; and
map the second codeword sequence to the QAM symbol, wherein
the communication module is further configured to output a modulated QAM symbol.

27. A communication apparatus, comprising a communication interface and a circuit, wherein the communication interface is configured to receive a to-be-interleaved first codeword sequence, and input the first codeword sequence to the circuit; the circuit is configured to perform the method according to any one of claims 1 to 25, to interleave the first codeword sequence to obtain a second codeword sequence, and map the second codeword sequence to a QAM symbol; and the communication interface is further configured to output a modulated QAM symbol.

28. A communication apparatus, comprising a module or a unit for performing the method according to any one of claims 1 to 25.

29. A communication apparatus, comprising:
a processor, wherein the processor is coupled to a memory, and the processor is configured to execute a computer program or instructions stored in the memory, to enable the communication apparatus to perform the method according to any one of claims 1 to 25.

30. A computer-readable storage medium, wherein the computer-readable storage medium stores computer instructions, and when the computer instructions are run on a computer, the method according to any one of claims 1 to 25 is implemented.

31. A computer program product, comprising computer instructions, wherein when the computer instructions are run on a computer, the method according to any one of claims 1 to 25 is implemented.
